# EUROPEAN PATENT SPECIFICATION

(11) **EP 0 923 114 B1**
(45) Date of publication and mention of the grant of the patent: **03.01.2007**
(21) Application number: 99200531.4
(22) Date of filing: 19.06.1996
(51) Int. Cl.: H01L 21/266, H01L 21/336

(54) **Process for self-aligned implantation**
Verfahren zur selbst-justierten Herstellung von implantierten Gebieten
Procédé de fabrication de zones implantées auto-alignées

(30) Priority: 19.06.1995 US 2426
(43) Date of publication of application: 16.06.1999
(62) Divisional of application: 96870078.1
(73) Proprietor: INTERUNIVERSITAIR MICRO-ELEKTRONICA CENTRUM VZW, 3001 Heverlee (BE)
(72) Inventor: Donaton Ricardo Alves, 3001 Heverlee (BE); Maex, Karen Irma Josef, 3020 Herent (BE); Verbeeck, Rita, 3110 Rotselaar (BE); Jansen, Philippe, 2250 Olen (BE); Rooyackers, Rita, 3010 Leuven (BE); Deferm, Ludo, 3581 Beverloo (BE); Baklanov, Mikhail Rodionovich, 3000 Leuven (BE)
(74) Representative: Van Malderen, Joëlle

(56) References cited:
- US-A- 5 162 259
- US-A- 5 320 974
- "SIMPLIFIED LIGHTLY DOPED DRAIN PROCESS" IBM TECHNICAL DISCLOSURE BULLETIN,US,IBM CORP. NEW YORK, vol. 30, no. 12, page 180-181 XP000124437 ISSN: 0018-8689
- ATSUSHI HORI ET AL: "A SELF-ALIGNED POCKET IMPLANTATION (SPI) TECHNOLOGY FOR 0.2-UM DUAL-GATE CMOS" IEEE ELECTRON DEVICE LETTERS,US,IEEE INC. NEW YORK, vol. 13, no. 4, page 174-176 XP000370700 ISSN: 0741-3106

## Description

### Field of the invention

The present invention is related to the use of an etching process of CoSi₂ layers as a process step for self-aligned pocket implantation in semiconductor devices.

### State of the art

The use of cobalt disilicide (CoSi₂) in microelectronics applications is becoming more and more important. In CMOS technology, with scaling down of dimensions, especially for CMOS technology manufacturing transistor with a gate length smaller than 0.35 µm, CoSi₂ has become an attractive material due to its better characteristics when compared to the more frequently used TiSi₂.

The interaction of a silicide film with chemicals and reactive gasses during further processing is an important issue to maintain the integrity of the film in the fully integrated structure. TiSi₂ is known to be very reactive with chemicals such as NH₄OH- and HF-based solutions. CoSi₂ is much more robust in that respect. Wet etching of CoSi₂ has even been considered very difficult in general.

The process described in the IBM Technical Disclosure Bulletin, Vol. 30, No. 12, pp. 180-181, focuses on creation of a simplified process for self-aligned pocket implantation using only one masking step by inverting the standard process sequence is and starts with formation of a double spacer, self-aligned silicidation, masking step, junction implant in the silicide, second space removal, lightly doped region implantation, mask stripping and junction anneal. Moreover, the refractory metal is used for shallow implant formation by dopant diffusion out of the refractory metal silicide and for withstanding high temperatures. The main problem with this process is indeed the fact that the standard process sequence is inverted and the junction anneal as last step can be problematic due to diffusion of the implants, which is the main reason for introducing two spacers.

Although in IEEE Electron Devices Letters, Vol. 13, No. 4, pp. 174-176, a self-aligned pocket implantation process for 0.2 submicron is presented, it must be made clear that TI-silicide suffers from the so-called narrow line effect. Consequently small gate lengths can be obtained only with non-classical expensive CMOS processing steps. In this presented process also an extra isotropic etchiing process using plasma is needed for removal of the SiN spacer, thereby introducing the danger of destroying the gate quality due to plasma charging.

US-A-5 162 259 discloses the etching of oxide sidewall spacers on CoSi₂ regions using diluted Hf suffered with ammonium fluoride. This process has been disclosed in the frame of fabrication of CMOS SRAM having buried contacts.

### Aims of the present invention

An object of the present invention is to improve the process of self-aligned pocket implantation using an etching process of CoSi₂ layers in semiconductor manufacturing process.

More particularly, this object is to suggest to use a specific process step based on selective etching of CoSi₂, while the other conventional process steps are still maintained. Accordingly, it is aimed is to affect as less as possible the global costs of a whole process integration in active transistors fabrication.

### Main characteristics of the present invention

The present invention is related to a process of a self-aligned pocket implantation in an active transistor having a small gate length comprising the steps of:
- defining an active area within a semiconductor substrate with a source region, a drain region and a gate region;
- defining a silicon oxide sidewall spacer in between said source and said gate regions and in between said drain and said gate regions;
- forming a self-aligned CoSi₂ top layer selectively on said exposed drain, gate, and source regions;
- selectively etching the silicon oxide spacer using a HF-based solution having a pH between 3 and 8.5 by tuning the HF-based solution so as to have a high etch rate for the oxide spacer with a minimum etch rate for the CoSi₂ layer;
- implanting dopants in the source and drain regions in order to achieve a self-aligned pocket implantation.

According to one preferred embodiment, the dopants are of the opposite kind than the source and drain implants, in order to reduce drain induced barrier lowering.

According to another preferred embodiment the dopants are of the same kind than the source and drain implants, in order to reduce the series resistance.

This last processes can be easily integrated in conventional CMOS process integration for devices having gate lengths less than 0.35 µm.

### Description of the figures

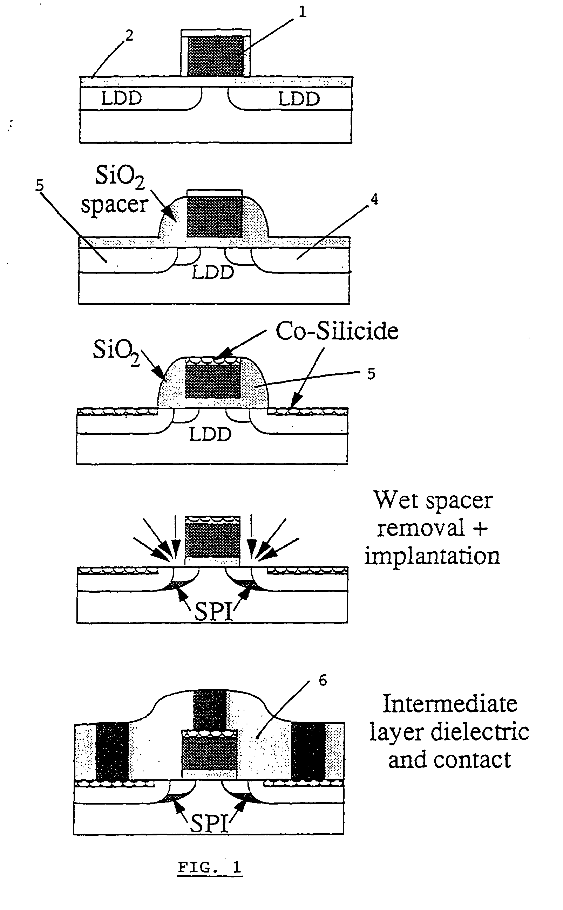

- Figures 1: represent cross section views of an active transistor according to the several steps of the formation of semiconductor having a self-aligned pocket implantation using selective removal of oxide spacer compared to CoSi₂ layers.

### Detailed description of the present invention

The present invention is related to a full integration process in order to fabricate active transistors using self-aligned pocket implantation.

In the prior art, a full semiconductor integration process in order to fabricate active transistors is known to use self-aligned pocket implantation. The full integration process starts with the definition of active area and field area, generally using local oxidation schemes. Wells to adjust for threshold voltage, to reduce anti-punch trough current and control the immunity versus latch-up can be implanted prior or after the active area and field definition process. Afterwards, after cleaning and conditioning the Si surface a high quality gate oxide will be thermally grown, followed by a chemical vapor deposition of a polycrystalline or amorphous Si layer. This layer will be implanted and annealed as not to destroy the gate during subsequent patterning.

After gate patterning, an implantation oxide is thermally grown. N-type and P-type lightly doped source and drain (LDD) are then implanted with respectively P or As and B or BF₂. An oxide layer is deposited uniformly over the wafer and subsequently etched without mask definition by an anisotropic dry etch. Due to the anisotropic etch, a spacer is formed at the poly sidewalls. The etch is performed until complete removal of the oxide on poly and source-drain regions. After cleaning, a new oxide is thermally grown. The gate and source-drain regions are then implanted and annealed.

After source/drain formation, the implantation oxide is removed, typically by a critical HF etch before Ti or Co sputtering for silicidation. Ti-sputtering is commonly used for dimensions equal and larger than 0.35 µm and Co-sputtering and Co alloys for smaller dimensions. The silicidation consists commonly of a first initial heating and reaction step, followed by a selective etch based on ammoniumhydroxide for Ti-silicide and based on sulphuric acid for Co-silicide, and a final reaction step for complete formation of a low resistance silicide.

After silicidation, an intermediate layer dielectric is deposited, which is then patterned for contact windows, filled with a conductor and finally interconnected by one or more metal layers, each separated by an intermediate metal dielectric.

With shrinking dimensions, it is noticed that the control of the gate on the carriers conducting the current under the gate reduces, due to the physical phenomenon called drain induced barrier lowering. The effect of drain induced barrier lowering can be countered by locally increasing the well dopant density for narrow gates. This can be done by implanting the well dopant at the same time as the LDD implantation but with a slightly deeper projected range or by a large angle tilted implant (LATID). This approach is called halo-implantation. This solution is very effective in decreasing the transistor leakage current for a maximum drive current, but due to the counterdoping the junction capacitance between source/drain regions and the substrate is increased and the depth of the source/drain regions is reduced. A better solution therefore is a pocket implantation self-aligned towards gate and silicide. The silicide has a larger stopping power towards implantation, about 1.5 times better than Si, so the well dopant implantation exceeds the projected range of the LDD, but not the junction depth and therefore it reduces the junction capacitance and does not reduce the depth.

The implantation can only be performed after the silicidation of the source/drain regions and requires therefore the use of disposable spacers. For a process using Ti-silicided, two types of disposable spacers have been reported: first, the use of a TiN spacer by Pfiester et al. from Motorola in "An integrated 0.5 µm CMOS disposable TiN LDD/Salicide spacer technology", IEDM 89, 781-784, wherein a TiN layer is therefore deposited by chemical vapor deposition in nitrogen ambient, and subsequently etched in an anisotropic plasma to form a spacer at the polysilicon gate sidewall. The spacer is removed during the selective etch based on ammoniumhydroxide after the first silicidation step. Secondly, the use of a SiN spacer by Hori et al. from Matsushita in "A Self-Aligned Pocket Implantation (SPI) Technology for 0.2 µm Dual Gate CMOS," IEDM 91, 641 - 644. In this case, the SiN spacer is formed by low pressure chemical vapor deposition of a uniform SiN layer and subsequent etch in an anisotropic plasma to form a spacer at the polysilicon gate sidewall. The spacer needs then to be removed after Ti-silicide formation. Only an isotropic plasma can remove the spacer selectively towards the Ti-silicide.

The main drawback shown in the first reference is that the deposition of a thick TiN layer and the subsequent anisotropic etching to obtain a spacer is not standardly available in a semiconductor manufacturing environment.

The main drawback of the second solution is extra development of an isotropic SiN etching process and the danger to destroy gate quality due to plasma charging.

The process according to the present invention is based on the use of the conventional semiconductor manufacturing process steps, as described in the prior art until gate formation and anneal.

After anneal, the implantation oxide of the junctions is removed by a wet chemical etch e.g. HF 2% (in H₂O). Co is sputtered on the surface and the subsequent silicidation is performed using a two step heat treatment with a selective etch after the first heat treatment. Up to this process step, all steps are common for a Co-silicide semiconductor manufacturing process.

According to a preferred embodiment described in relation with figs. 1, the full integration process starts with the definition of active area and field area, generally using local oxidation schemes. Wells to adjust for threshold voltage, to reduce anti-punch through current and control the immunity versus latch-up can be implanted prior or after the active area and field definition process. Afterwards, after cleaning and conditioning the Si surface a high quality gate oxide will be thermally grown, followed by a chemical vapor deposition of a polycrystalline or amorphous Si layer. This layer will be implanted and annealed as not to destroy the gate during subsequent patterning.

After gate (1) patterning, an implantation oxide (2) is thermally grown. n-type and p-type lightly doped source (3) and drain (4) (LDD) are then implanted with respectively P or As and B or BF₂ (see fig. 1a)

An oxide layer is deposited (Low Pressure Chemical Vapor Deposition) uniformly over the wafer and subsequently etched without mask definition by an anisotropic dry etch. Due to the anisotropic etch, a spacer (5) is formed at the poly sidewalls. The etch is performed until complete removal of the oxide on poly and source-drain regions. After cleaning, a new oxide (6) is thermally grown. The gate and source-drain regions are then implanted and annealed (see fig. 1b).

After junction formation, the implantation oxide is removed, typically by a critical HF etch before Co or Co-alloy sputtering for silicidation. The silicidation consists of a first initial heating and reaction step, followed by a selective etch based on a sulphuric acid hydrogen peroxide solution, and a final reaction step for complete formation of a low resistance silicide (see fig. 1c).

After Co-silicidation, the oxide spacer is etched selectively towards the Co-silicide by the right choice of the pH of an aqueous HF chemical etch. To improve the process window for the selective etch, it is preferable to use a fast oxide etching HF based solution with a pH close to neutral. The etch rate of the Co-silicide in a near neutral HF based solution is nearly independent of the HF concentration. To achieve an acceptable process window towards manufacturing yield and quality, a HF solution with HF concentration higher than 2% is required to etch the spacer in a short time and to reduce the time during which the Co-silicide is in contact with the etch solution. The pH of the solution is required to be higher than 3 to obtain a significantly low etch rate of the Co-silicide during the exposure time.

The advantage of the newly proposed manufacturing process is the use of a Co-silicide layer, with well controlled etching characteristics to commonly available chemicals as hydrogen fluoride (HF) and sulphuric acid (H₂SO₄).

For the selective etch of an oxide spacer, available in most standard semiconductor manufacturing processes, HF solutions with a pH > 3 and preferably with a pH > 5.5 can be tuned to have a high etch rate for the oxide spacer and a minimum etchrate for the Co-silicide layer, as described in the annexed Table 1.

Moreover, this manufacturing process requires a minimum of process development, as the used chemicals are already used in the conventional process and the influence of this wet chemical etchant on gate oxide quality has already been extensively studied.

Preferably, the H-based solution is a buffered HF(BHF) solution. The BHF solution is formed by mixing 1 part of HF 50% and 7 parts of NH₄F 40%. The pH of this solution is higher than 3. Moreover the BHF etch of the oxide spacer is selective towards the gate oxide etch with a ratio about 3:1. The etching time in this case is 20 seconds.

After removal of the oxide spacer, a pocket implantation is performed, self-aligned towards the gate and the source-drain junctions. This pocket implantation counters the drain induced barrier lowering phenomenon for small gatelength CMOS devices, allows for maximum drive current and a minimum leakage current, and does not increase the junction capacitance of source and drain junctions considerably (see fig. 1d)

For nMOS devices a B pocket implantation at 40 keV is performed and for pMOS devices a P pocket implantation at 100 keV.

After pocket implantation, conventional CMOS manufacturing process is continued. An intermediate layer dielectric is deposited, which is patterned for contact windows, filled with a conductor and finally interconnected by one or more metal layers, each separated by an intermediate metal dielectric (see fig. 1e).

**Table 1**

| Composition | | | | | | pH | etch rate (nm/s) | | |
|---|---|---|---|---|---|---|---|---|---|
| ml | ml | ml | | | | | | | |
| HF 49% | H2O | | | HF2% | | 1.5 | | 0.22 | |
| 20 | 470 | | | | | | | | |
| | | | | | | | | | |
| HF 49% | H2O | H2SO4 | | HF2% | | | | | |
| 20 | 370 | 100 | | | | 0 | | 2.15 | |
| | | | | | | | | | |
| HF49% | H2O | H2SO4 | | (no HF) | | | | | |
| 0 | 390 | 100 | | | | 0 | | 0 | |
| | | | | | | | | | |
| HF 49% | H2O | H2SO4 | | HF2% | | | | | |
| 20 | 460 | 10 | | | | 0.5 | | 0.38 | |
| | | | | | | | | | |
| HF 49% | H2O | NH4OH | | HF2% | | 8.5 | | 0 | |
| 20 | 430 | 40 | | | | | | | |
| | | | | | | | | | |
| HF 49% | H2O | NH4OH | | HF2% | | 3 | | 0.15 | |
| 20 | 450 | 20 | | | | | | | |
| | | | | | | | | | |
| HF 49% | H2O | NH4OH | | HF2% | | 4 | | 0.13 | |
| 20 | 440 | 30 | | | | | | | |
| | | | | | | | | | |
| HF49% | H2O | NH4OH | | HF2% | | 5 | | 0.1 | |
| 20 | 435 | 35 | | | | | | | |
| | | | | | | | | | |
| HF49% | H2O | NH4OH | | HF2% | | 2.5 | | 0.13 | |
| 20 | 455 | 15 | | | | | | | |
| | | | | | | | | | |
| HF49% | H2O | HCl | | HF2% | | 0.52 | | 0.34 | |
| 40 | 930 | 30 | | | | | | | |
| | | | | | | | | | |
| HF49% | H2O | HCl | | HF2% | | 0.22 | | 0.38 | |
| 40 | 900 | 60 | | | | | | | |
| | | | | | | | | | |
| HF49% | H2O | HCl | | HF2% | | 0.04 | | 0.42 | |
| 40 | 870 | 90 | | | | | | | |
| | | | | | | | | | |
| HF49% | H2O | HCl | | HF2% | | -0.08 | | 0.47 | |
| 40 | 840 | 120 | | | | | | | |
| | | | | | | | | | |
| HF49% | H2O | | | | | | | | |
| 5 | 485 | | | HF0.5% | | | | 0.18 | |
| | | | | | | | | | |
| B-HF | | | (from the bottle) | | | 4.5 | | 0.045 | |
| 500 | | | | | | | | | |
| | | | | | | | | | |
| B-HF | H2O | | | BHF 1/12.5 | | 4 | | 0.08 | |
| 40 | 460 | | | | | | | | |
| | | | | | | | | | |
| B-HF | H2O | NH4OH | | BHF 1/12.5 | | 6 | | 0.04 | |
| 40 | 450 | 10 | | | | | | | |
| | | | | | | | | | |
| B-HF | H2O | H2SO4 | | BHF 1/12.5 | | 1.5 | | 0.14 | |
| 40 | 450 | 10 | | | | | | | |
| | | | | | | | | | |
| B-HF | H2O | | | BHF 1/7.5 | | 4 | | 0.07 | |
| 60 | 390 | | | | | | | | |
| | | | | | | | | | |
| B-HF | H2O | NH4OH | | BHF 1/7.5 | | 5.5 | | 0.07 | |
| 60 | 380 | 10 | | | | | | | |
| | | | | | | | | | |
| B-HF | H2O | H2SO4 | | BHF 1/7.5 | | 2.5 | | 0.09 | |
| 60 | 380 | 10 | | | | | | | |
| | | | | | | | | | |

## Claims

1. Process of a self-aligned pocket implantation in an active transistor having a small gate length comprising the steps of:
- defining an active area within a semiconductor substrate with a source region, a drain region and a gate;
- defining a silicon oxide sidewall spacer in between said source region and said gate and in between said drain region and said gate;
- forming a self-aligned CoSi₂ top layer selectively on said exposed drain, and source regions and gate
- selectively etching the silicon oxide sidewall spacer using a HF-based solution having a pH between 3 and 8.5 by tuning the HF-based solution so as to have a high etch rate for the oxide spacer with a minimum etch rate for the CoSi₂ layer;
- implanting dopants in the source and drain regions in order to achieve a self-aligned pocket implantation.

2. Process of self-aligned pocket implantation according to claim 1 wherein the dopants are of the opposite kind than the source and drain implants.

3. Process of self-aligned pocket implantation according to claim 1 wherein the dopants are of the same kind than the source and drain implants.

4. Use of the process as claimed in anyone of the preceding claims in a CMOS process integration having gate length dimensions less than 0.35 µm.

## Patentansprüche

1. Verfahren für eine selbstjustierte Pocket-Implantation in einem aktiven Transistor mit einer geringen Gatelänge, folgende Schritte umfassend:
- Festlegen eines aktiven Gebiets in einem Halbleitersubstrat mit einem Source-Gebiet, einem Drain-Gebiet und einem Gate,
- Festlegen eines Siliziumoxid-Seitenwand-Abstandshalters zwischen dem Source-Gebiet und dem Gate und zwischen dem Drain-Gebiet und dem Gate;
- Bilden einer selbstjustierten CoSi₂-Oberschicht selektiv auf den freigelegten Drain- und Source-Gebieten und dem Gate;
- selektives Ätzen des Siliziumoxid-Seitenwand-Abstandshalters mit einer HF-basierten Lösung mit einem pH-Wert zwischen 3 und 8,5, indem die HF-basierte Lösung solcherart abgestimmt wird, dass sie eine hohe Ätzgeschwindigkeit für den Oxid-Abstandshalter und eine minimale Ätzgeschwindigkeit für die CoSi₂-Schicht aufweist;
- Implantieren von Dotierstoffen in die Source- und Drain-Gebiete, um eine selbstjustierte Pocket-Implantation zu erreichen.

2. Verfahren für selbstjustierte Pocket-Implantation nach Anspruch 1, wobei die Dotierstoffe gegenüber den Source- und Drain-Implantaten von entgegengesetzter Art sind.

3. Verfahren für selbstjustierte Pocket-Implantation nach Anspruch 1, wobei die Dotierstoffe von der gleichen Art wie die Source- und Drain-Implantate sind.

4. Verwendung des Verfahrens nach einem der vorhergehenden Ansprüche bei einer Integrierung eines CMOS-Verfahrens mit Gatelängenabmessungen von weniger als 0,35 µm.

## Revendications

1. Procédé d'implantation de poches auto-alignées dans un transistor actif ayant une petite longueur de grille, comprenant les étapes suivantes :
- la définition d'une zone active dans un substrat semi-conducteur avec une région de source, une région de drain et une grille;
- la définition d'un espaceur de parois latérales d'oxyde de silicium entre ladite région de source et ladite grille et entre ladite région de drain et ladite grille;
- la formation d'une couche supérieure de CoSi₂ auto-alignée sélectivement sur lesdites régions exposées de drain et de source et la grille;
- la gravure sélective de l'espaceur de parois latérales d'oxyde de silicium en utilisant une solution à base de HF ayant un pH de 3 à 8,5 en réglant la solution base de HF de manière à avoir un taux de gravure élevé pour l'espaceur d'oxyde avec un taux de gravure minimum pour la couche de CoSi₂;
- l'implantation d'agents dopants dans les régions de source et de drain pour obtenir une implantation de poches auto-alignées.

2. Procédé d'implantation de poches auto-alignées selon la revendication 1, dans lequel les agents dopants sont du type opposé aux implants de source et de drain.

3. Procédé d'implantation de poches auto-alignées selon la revendication 1, dans lequel les agents dopants sont du même type que les implants de source et de drain.

4. Utilisation du procédé selon l'une quelconque des revendications précédentes dans une intégration de procédé CMOS ayant des dimensions de longueur de grille inférieures à 0,35 µm.
